# EUROPÄISCHE PATENTSCHRIFT

(11) **EP 0 736 907 B1**
(45) Veröffentlichungstag und Bekanntmachung des Hinweises auf die Patenterteilung: **22.12.1999**
(21) Anmeldenummer: 96104243.9
(22) Anmeldetag: 18.03.1996
(51) Int. Cl.: H01L 29/423, H01L 23/485

(54) **Feldeffekt steuerbares Halbleiterbauelement mit einem integrierten ohmischen Widerstand**
Semiconductor field effect device with an integrated ohmic resistance
Dispositif semi-conducteur à effet de champ à résistance intégrée ohmique

(30) Priorität: 05.04.1995 DE 19512799
(43) Veröffentlichungstag der Anmeldung: 09.10.1996
(73) Patentinhaber: SIEMENS AKTIENGESELLSCHAFT, 80333 München (DE)
(72) Erfinder: Miller, Gerhard, Dr.-Ing., 86929 Penzing (DE); Laska, Thomas, Dipl.-Phys., 80796 München (DE); Porst, Alfred Obering, 81249 München (DE)

(56) Entgegenhaltungen:
- US-A- 4 920 388
- US-A- 5 227 655
- PATENT ABSTRACTS OF JAPAN vol. 017, no. 356 (E-1394), 6.Juli 1993 & JP-A-05 055588 (SANYO ELECTRIC CO LTD), 5.März 1993,
- PATENT ABSTRACTS OF JAPAN vol. 011, no. 306 (E-546), 6.Oktober 1987 & JP-A-62 098670 (MITSUBISHI ELECTRIC CORP), 8.Mai 1987,
- THRONGNUMCHAI K: "A study on the effect of the gate contact geometry and dimensions on ESD failure threshold level of power MOSFET's" , IEEE TRANSACTIONS ON ELECTRON DEVICES, JULY 1994, USA, VOL. 41, NR. 7, PAGE(S) 1282 - 1287 , ISSN 0018-9383 XP000453329 * Zusammenfassung; Abbildung 2 *
- PATENT ABSTRACTS OF JAPAN vol. 010, no. 008 (E-373), 14.Januar 1986 & JP-A-60 171771 (HITACHI SEISAKUSHO KK), 5.September 1985,

## Beschreibung

Die Erfindung bezieht sich auf ein durch Feldeffekt steuerbares Halbleiterbauelement mit einem Halbleiterkörper, auf dem eine gegen die Oberfläche des Halbleiterkörpers isolierte dotierte Polysiliziumschicht angeordnet ist, von der ein erster Teil eine Gateelektrode ist und ein zweiter Teil eine Kontaktfläche für eine Gatezuleitung.

Durch Feldeffekt steuerbare Halbleiterbauelemente der erwähnten Art, z.B. Leistungs-MOSFET oder IGBT, sind Stand der Technik. Z.B. in Modulen werden im allgemeinen viele solcher Halbleiterbauelemente einander parallel geschaltet. Aufgrund der parasitären Leitungsinduktivitäten im Steuerkreis neigen solche Anordnungen beim Leitendsteuern zu Schwingungen, die ein definiertes Einschalten verhindern.

Bisher wurden daher in die Module Widerstandschips eingebaut, die einerseits mit den Gatenanschlüssen der Halbleiterbauelemente und andererseits mit externen Gateanschlüssen des Moduls durch Bonddrähte verbunden werden müssen. Diese Lösung erfordert zusätzliche Fläche im Modul und zusätzliche Verbindungsleitungen.

In der US 4,920,388 ist ein Leistungs-MOS-Transistor beschrieben, der eine polykristalline Siliziumschicht beinhaltet, die als Widerstand zwischen einer Gate-Metallisierung und dem Gateanschluß des Leistungs-MOS-Transistors dient. Weiterhin beinhaltet das Halbleiterbauelement einen zweiten Bereich einer Gate-Metallisierung, die benachbart der aktiven Source-Gate-Region des Bauelementes liegt.

In Patent Abstracts of Japan, Vol. 017, No. 356, 6. Juli 1993 + JP-A-05055588 ist ein Multi-Chip-ähnlicher MOS-Feldeffekt-transistor beschrieben, der einen Widerstand mit einer höheren Impedanz aufweist als ein Bonddraht, und der zwischen der Gate-Elektrode und der Gate-Kontaktfläche liegt. Der Widerstand ist durch eine leicht dotierte Polysiliziumschicht in einem vorgegebenen Bereich gebildet.

In Patent Abstracts of Japan, Vol. 011, No. 306, 6. Oktober 1987 + JP-A-62098670 ist ein Halbleiterbauelement mit einem mit dem Gate in Serie geschaltenen Widerstand beschrieben, der zwischen der Gate-Kontaktfläche und dem Gate angeordnet ist. Der Widerstand besteht aus Polysilizium und sein Widerstandswert kann durch Ionenimplantation eingestellt werden.

In dem Artikel "A Study on the Effect of the Gate Contact Geometry and Dimensions on ESD Failure Threshold Level of Power MOSFET's", K. Throngnumchai, IEEE Transactions on Electron Devices, July 1994, USA, Vol. 41, No. 7, Pages 1282 - 1287 ist beschrieben, wie durch Ausgestaltung der Gate-Kontaktelektrode und über Dimensionierung Fehler des Leistungs-MOSFETs durch elektrostatische Entladung (ESD) vermieden werden können. Zu diesem Zweck sollte die Gate-Kontaktelektrode in ihrer Breite vergrößert werden sowie der aus Polysilizium bestehende Widerstand zwischen dem Gateanschluß und der Kontaktelektrode verringert werden.

Der Erfindung liegt die Aufgabe zugrunde, ein durch Feldeffekt steuerbares Halbleiterbauelement der beschriebenen Art derart weiterzubilden, daß eine einfache und kostengünstige Herstellbarkeit möglich ist. Ferner soll die Kontaktfläche für eine Gatezuleitung einfach und sicher zu kontaktieren sein.

Diese Aufgabe wird dadurch gelöst, daß die Kontaktfläche am Rand mit mindestens einer Aussparung versehen ist, wobei der ohmsche Widerstand in der Aussparung angeordnet ist.

Weiterbildungen der Erfindung sind Gegenstand der Unteransprüche.

Die Erfindung wird anhand einiger Ausführungsbeispiele in Verbindung mit den Figuren 1 bis 4 näher erläutert. Es zeigen
- Figuren 1 bis 3: die Aufsicht auf je ein Ausführungsbeispiel und
- Figur 4: einen Schnitt durch ein weiteres Ausführungsbeispiel.

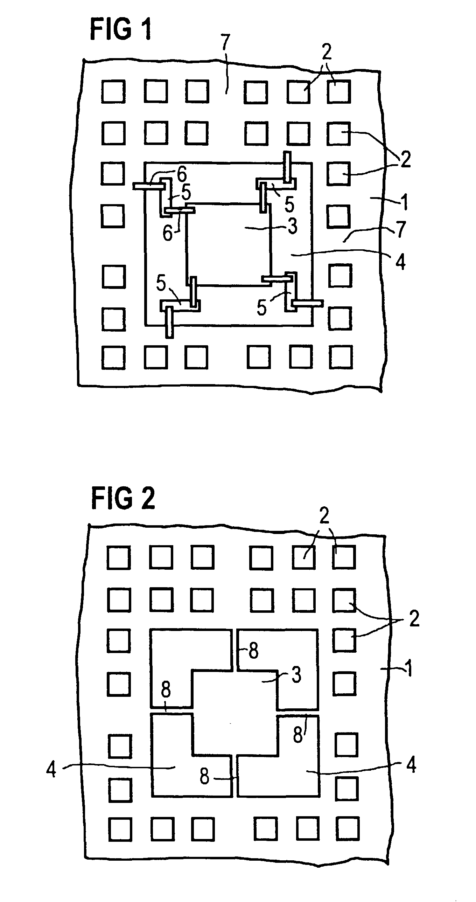

In Figur 1 ist ein Ausschnitt eines durch Feldeffekt steuerbaren Halbleiterbauelementes dargestellt. Die Oberfläche eines Halbleiterkörpers ist mit einer Isolierschicht bedeckt (nicht dargestellt), auf der wiederum eine dotierte Polysiliziumschicht angeordnet ist. Die Polysiliziumschicht hat einen ersten Teil 1, der als Gateelektrode dient und einen zweiten Teil 3, der die Kontaktfläche für die Befestigung einer Gatezuleitung bildet. Die Gateelektrode 1 der Polysiliziumschicht ist mit Öffnungen 2 versehen, durch die -isoliert gegen die Polysiliziumschicht- über Kontakt löcher die Sourcezonen der einzelnen Zellen des Halbleiterbauelementes kontaktiert sind. Diese Kontaktlöcher bilden ein regelmäßiges, über die Oberfläche der Gateelektrode 1 verteiltes Muster. Zur Aufnahme von sogenannten Gatekontaktfingern zur besseren Verteilung des Gatepotentials bei größeren Chips können zwischen benachbarten Zellen breitere Flächen 7 frei von Kontaktlöchern sein.

Die Gateelektrode 1 hat eine Aussparung 4, in der die Kontaktfläche 3 angeordnet ist. Zwischen der Kontaktfläche 3 und der Gateelektrode 1 ist das dotierte Polysilizium z.B. durch Ätzen unterbrochen. In der Aussparung 4 liegen zwischen der Kontaktfläche 3 und der Gateelektrode 1 Inseln 5, die integrierte ohmsche Widerstände bilden. Sie bestehen vorzugsweise aus dotiertem polykristallinem Silizium und haben die gleiche Dotierung wie die Kontaktfläche 3 und die Gateelektrode 1. Sie haben vorzugsweise auch die gleiche Dicke wie 1 und 3.

Die Inseln 5 sind über Leiterbahnen 6 einerseits mit der Gateelektrode 1 und andererseits mit der Kontaktfläche 3 verbunden.

Die Inseln 5 können gleichzeitig mit der Strukturierung der Kontaktfläche 3 und der Gateelektrode 1 erzeugt werden. Ihre Länge und ihr Querschnitt richten sich danach, welche Größe der Gatevorwiderstand R_{g} haben soll.

Im Ausführungsbeispiel nach Figur 2 ist die Kontaktfläche 3 mit der Gateelektrode 1 durch Stege 8 verbunden. ist. Diese bestehen ebenfalls aus Polysilizium. Ihre Länge und ihr Querschnitt richten sich wiederum nach demjenigen Widerstandswert, den der Gatevorwiderstand R_{g} haben soll.

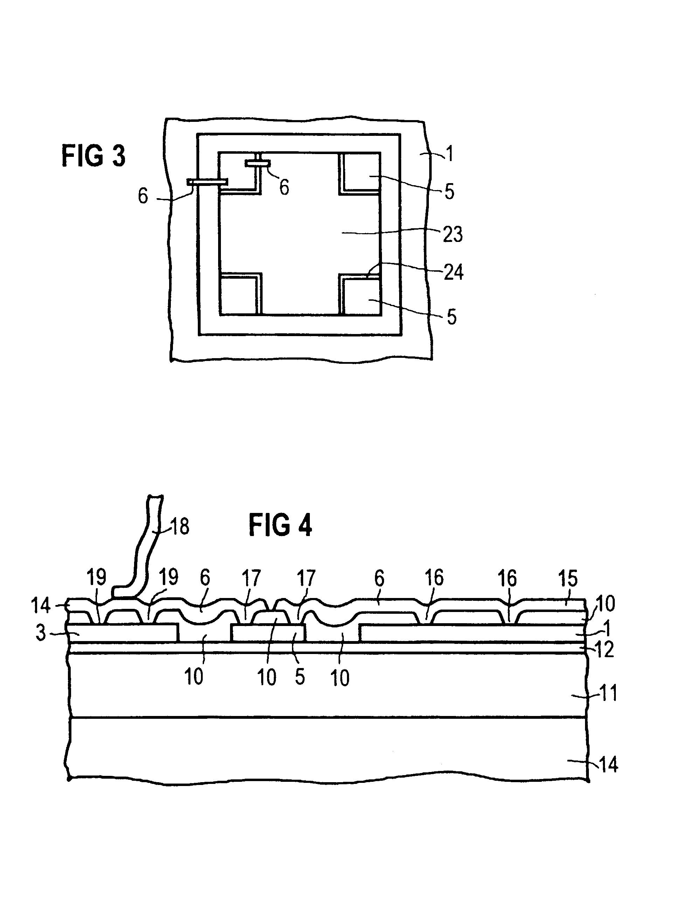

Das Ausführungsbeispiel nach Figur 3 unterscheidet sich von dem der Figur 1 dadurch, daß die Inseln 5 in Aussparungen 24 einer Kontaktfläche 23 angeordnet sind. Die Inseln 5 werden hier wie im Ausführungsbeispiel nach Figur 1 durch Leiterbahnen einerseits mit der Kontaktfläche 23 und andererseits mit der Gateelektrode 1 kontaktiert. Die Aussparungen 24 können wie dargestellt an den Ecken der Kontaktfläche 23 liegen oder auch an anderen Stellen des Umfangs. Die Inseln 5 können wie die Aussparungen quadratisch sein, andere Formen sind möglich.

In Figur 4 ist dargestellt, daß die Oberfläche eines Halbleiterbauelementes mit den Halbleiterzonen 11, 14 mit einer Oxidschicht 12 bedeckt ist. Auf der Oxidschicht 12 liegt die strukturierte Polysiliziumschicht bestehend aus der Kontaktfläche 3, den Inseln 5 und der Gateelektrode 1. Auf der Polysiliziumschicht liegt eine Isolierschicht 10, die sowohl die Gateelektrode 1 als auch die Kontaktfläche 3 und die Inseln 5 bedeckt. Auf der Oxidschicht 10 ist oberhalb der Kontaktfläche 3 eine Metallschicht 14 angeordnet. Auf der Gateelektrode 1 sitzt ein in Verbindung mit Figur 1 erwähnter Gatekontaktfinger 15. Auch er ist durch eine Metallschicht gebildet. Die Metallschicht 14 auf der Kontaktfläche 3 ist über Kontakt löcher 19 mit der darunter liegenden Polysiliziumschicht elektrisch verbunden. Auf gleiche Weise ist der Gatekontaktfinger 15 über Kontakt löcher 16 mit der Gatelektrode 1 verbunden. Da auch die Insel 5 mit der Oxidschicht 10 bedeckt ist, sind die getrennten Leiterbahnen 6 über Kontaktlöcher 17 mit dem Polysilizium der Insel 5, die den Widerstand darstellt, verbunden. Die Metallschicht 14 steht über einen Bonddraht 18 mit einem externen Anschluß des Halbleiterbauelements in Verbindung.

Die Inseln 5 bzw. die Stege 8 (Figur 2) werden gemäß einem Ausführungsbeispiel durch 0,5 bis 1 µm dickes Polysilizium gebildet. Ihre Breite und ihre Länge können z.B. 0,5 mm betragen. Das Polysilizium kann z.B. derart dotiert sein, daß es einen Widerstand von 20 Ohm/□ hat.

Beim Schnitt nach Figur 4 wurde vereinfachend nur eine einzige Widerstandsinsel 5 dargestellt. Es können jedoch wie in den Figuren 1, 2 und 3 auch mehrere Widerstände integriert werden. Entsprechend der Anzahl der parallelgeschalteten Widerstände verringert sich dann der Widerstandswert für R_{g}.

## Patentansprüche

1. Durch Feldeffekt steuerbares Halbleiterbauelement mit einem Halbleiterkörper, auf dem eine gegen die Oberfläche des Halbleiterkörpers isolierte dotierte Polysiliziumschicht angeordnet ist, von der ein erster Teil eine Gateelektrode (1) ist und ein zweiter Teil eine Kontaktfläche (3) für eine Gatezuleitung, worin die Kontaktfläche mit der Gateelektrode über mindestens einen zwischen der Kontaktfläche (3) und Gateelektrode (1) liegenden integrierten ohmschen Widerstand elektrisch verbunden ist, wobei der ohmsche Widerstand aus dotiertem polykristallinem Silizium besteht,
**dadurch gekennzeichnet,** daß die Kontaktfläche (23) am Rand mit mindestens einer Aussparung (24) versehen ist und daß der ohmsche Widerstand (5) in der Aussparung angeordnet ist.

2. Halbleiterbauelement nach Anspruch 1,
**dadurch gekennzeichnet,** daß der ohmsche Widerstand über mindestens eine Leiterbahn (6) mit der Kontaktfläche (3) und über mindestens eine Leiterbahn (6) mit der Gateelektrode (1) verbunden ist.

3. Halbleiterbauelement nach Anspruch 1,
**dadurch gekennzeichnet,** daß die Kontaktfläche (3) rechteckig ausgebildet ist und daß an oder in der Nähe jeder Ecke ein ohmscher Widerstand (5) angeordnet ist.

4. Halbleiterbauelement nach Anspruch 3,
daß jede Ecke der Kontaktfläche eine quadratische Aussparung (24) hat und daß in jeder Aussparung ein quadratisch ausgebildeter ohmscher Widerstand (5) angeordnet ist.

5. Halbleiterbauelement nach Anspruch 1 oder 2,
**dadurch gekennzeichnet**, daß die Kontaktfläche (3), der ohmsche Widerstand (5) und die Gateelektrode (1) mit einer Isolierschicht (10) bedeckt sind, daß auf der Isolierschicht oberhalb der Gateelektrode und oberhalb der Kontaktfläche je eine Metallschicht (14, 15) liegt, die mit der Gateelektrode bzw. der Kontaktfläche über in der Isolierschicht vorgesehene Kontaktlöcher (16, 19) elektrisch verbunden sind und daß die Leiterbahnen (6) mit dem ohmschen Widerstand (5), mit der Kontaktfläche (3) und mit der Gateelektrode (1) ebenfalls über Kontaktlöcher (17) elektrisch verbunden sind.

## Claims

1. Field effect-controllable semiconductor component having a semiconductor body on which is arranged a doped polysilicon layer which is insulated from the surface of the semiconductor body, a first part of which polysilicon layer is a gate electrode (1) and a second part of which polysilicon layer is a contact area (3) for a gate supply lead, in which the contact area is electrically connected to the gate electrode via at least one integrated non-reactive resistor situated between the contact area (3) and the gate electrode (1), the non-reactive resistor being composed of doped polycrystalline silicon,
characterized in that the contact area (23) is provided with at least one cutout (24) at the edge, and in that the non-reactive resistor (5) is arranged in the cutout.

2. Semiconductor component according to Claim 1,
characterized in that the non-reactive resistor is connected to the contact area (3) via at least one interconnect (6) and is connected to the gate electrode (1) via at least one interconnect (6).

3. Semiconductor component according to Claim 1,
characterized in that the contact area (3) is designed to be rectangular, and in that a non-reactive resistor (5) is arranged at or in the vicinity of each corner.

4. Semiconductor component according to Claim 3,
characterized in that each corner of the contact area has a square cutout (24), and in that a square non-reactive resistor (5) is arranged in each cutout.

5. Semiconductor component according to Claim 1 or 2,
characterized in that the contact area (3), the non-reactive resistor (5) and the gate electrode (1) are covered with an insulating layer (10), in that a respective metal layer (14, 15) lies on the insulating layer above the gate electrode and above the contact area, which metal layers are electrically connected respectively to the gate electrode and to the contact area via contact holes (16, 19) provided in the insulating layer, and in that the interconnects (6) are electrically connected to the non-reactive resistor (5), to the contact area (3) and to the gate electrode (1) likewise via contact holes (17).

## Revendications

1. Composant à semi-conducteur pouvant être commandé par effet de champ et ayant un corps semi-conducteur sur lequel est disposée une couche de polysilicium dopé isolée vis-à-vis de la surface du corps semi-conducteur, couche de silicium dont une première partie est une électrode (1) de grille et une seconde partie une surface (3) de contact pour un conducteur allant à la grille, la surface de contact étant reliée électriquement à l'électrode de grille par au moins une résistance ohmique intégrée se trouvant entre la surface (3) de contacte et l'électrode (1) de grille, la résistance ohmique étant constituée de silicium polycristallin dopé,
caractérisé en ce que la surface (23) de contact est munie sur le bord d'au moins un évidement (24) et en ce que la résistance (5) ohmique est disposée dans l'évidement.

2. Composant à semi-conducteur suivant la revendication 1,
caractérisé en ce que la résistance ohmique est reliée par au moins une piste (6) conductrice à la surface (3) de contact et par au moins une piste (6) conductrice à l'électrode (1) de grille.

3. Composant à semi-conducteur suivant la revendication 1,
caractérisé en ce que la surface (3) de contact est rectangulaire et en ce que à chaque sommet ou à proximité de chaque sommet est prévue une résistance (5) ohmique.

4. Composant à semi-conducteur suivant la revendication 3,
caractérisé en ce que chaque sommet de la surface de contact a un évidement (24) carré et en ce que dans chaque évidement est placée une résistance (5) ohmique carrée.

5. Composant à semi-conducteur suivant la revendication 1 ou 2,
caractérisé en ce que la surface (3) de contact, la résistance (5) ohmique et l'électrode (1) de grille sont revêtues d'une couche (10) isolante, en ce qu'il s'applique sur la couche isolante au-dessus de l'électrode de grille et au-dessus de la surface de contact respectivement une couche (14, 15) métallique qui est reliée électriquement à l'électrode de grille et à la surface de contact par des trous (16, 19) de contact prévus dans la couche isolante, et en ce que les pistes (6) conductrices sont reliées électriquement à la résistance (5) ohmique, à la surface (3) de contact et à l'électrode (1) de grille également par des trous (17) de contact.
